(19)

Europäisches
Patentamt
European
Patent Office
Office européen
des brevets

(11) **EP 3 254 787 A1**

(12) **EUROPEAN PATENT APPLICATION**
published in accordance with Art. 153(4) EPC

(43) Date of publication:
**13.12.2017 Bulletin 2017/50**

(21) Application number: **15881213.1**

(22) Date of filing: **14.12.2015**

(51) Int Cl.:
**B23B 27/14** [(2006.01)]  **C23C 14/06** [(2006.01)]

(86) International application number:
**PCT/JP2015/084914**

(87) International publication number:
**WO 2016/125396 (11.08.2016 Gazette 2016/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **05.02.2015 JP 2015021432**
**07.05.2015 JP 2015094995**

(71) Applicant: **Kabushiki Kaisha Kobe Seiko Sho (Kobe Steel, Ltd.)**
**Kobe-shi, Hyogo 651-8585 (JP)**

(72) Inventors:
• **YAMAMOTO, Kenji**
  **Hyogo 651-2271 Japan (JP)**
• **NII, Hiroaki**
  **Hyogo 651-2271 (JP)**

(74) Representative: **Müller-Boré & Partner**
**Patentanwälte PartG mbB**
**Friedenheimer Brücke 21**
**80639 München (DE)**

(54) **HARD COATING FILM**

(57)    A hard coating film which is formed on a base and satisfies a composition represented by formula (1). $Cr_{1-a}Mg_a(B_xC_yN_{1-x-y})$ (1) (In formula (1), a, x and y represent respective atomic ratios of Mg, B and C, and respectively satisfy $0.05 \leq a \leq 0.30$, $0 \leq x \leq 0.20$ and $0 \leq y \leq 0.30$.)

EP 3 254 787 A1

**Description**

TECHNICAL FIELD

The present invention relates to a hard film, and particularly to a hard film having excellent adhesion resistance and wear resistance.

BACKGROUND ART

A titanium-based metal such as pure titanium or a titanium alloy has properties such as high strength at a high temperature and low thermal conductivity. Accordingly, when cutting is performed using the titanium-based metal as a material to be cut, heat generated during the cutting is less likely to escape to a side of the material to be cut or a side of chips, and is liable to accumulate on a cutting edge of a cutting tool. As a result, the cutting edge temperature is liable to increase. Further, titanium is chemically active, so that titanium adhesion to the tool is liable to occur with an increase in the above-mentioned cutting edge temperature. The wear of the tool is easily progressed by this adhesion, and there is a problem that the wear resistance is decreased, resulting in a shortened tool life. The adhesion of a metal such as the titanium-based metal is hereinafter sometimes simply referred to as "adhesion".

In order to suppress the above-mentioned adhesion of the titanium-based metal during the cutting, the cutting has hitherto been generally performed by a wet process and at a low cutting rate. However, improvement in productivity is required, and to the cutting tool for the above-mentioned titanium-based metal, it is required that the above-mentioned adhesion can be suppressed without decreasing the cutting rate.

In order to satisfy the above-mentioned requirement, attempts have been made to suppress the adhesion by applying a coating onto the cutting edge of the cutting tool, thereby increasing the cutting rate. For example, as the above-mentioned coating, a film of a high-melting compound such as TiAlN has hitherto been proposed. Further, Patent Document 1 shows a surface covering cutting tool for cutting a titanium alloy, which is characterized in that the tool is formed of a compound composed of either one or both elements of Al, and Cr or V and any one or more elements of nitrogen, carbon and oxygen. Furthermore, Patent Document 1 shows that when the above-mentioned compound contains V, V oxide having a low melting point acts as a lubricant in a high-temperature environment during cutting, whereby an effect of suppressing adhesion of a material to be cut can be expected.

In addition, Patent Document 2 shows a cutting tool improved in properties suitable for cutting titanium and an alloy thereof, which includes a substrate containing tungsten carbide and one coating of a coating selected from the group consisting of tungsten carbide and boron carbide and adhered to the above-mentioned substrate by a physical vapor-deposition process and a coating including boron carbide and adhered to the above-mentioned substrate by a chemical vapor-deposition process.

PRIOR ART DOCUMENTS

PATENT DOCUMENTS

Patent Document 1: JP-A-2005-262389
Patent Document 2: JP-A-H09-216104

SUMMARY OF THE INVENTION

TECHNICAL PROBLEMS

An object of the present invention is to provide a hard film which can more suppress adhesion of a component of a material to be cut during cutting than a film of a conventionally used high-melting compound such as TiAlN, in the case where it is formed as a hard film of a cutting tool, to achieve satisfactory cutting even when the material to be cut is a titanium-based metal, and a hard film covering member such as a cutting tool, in which the hard film is formed on/above the substrate. The property of suppressing the adhesion of the component of the material to be cut during the cutting is hereinafter sometimes referred to as "adhesion resistance".

SOLUTION TO PROBLEMS

A hard film which could solve the problem(s) is a hard film to be formed on/above a substrate, which satisfies a composition represented by the following formula (1). In the following, this hard film may be referred to as a (Cr,Mg)(B, C,N) film.

$$Cr_{1-a}Mg_a(B_xC_yN_{1-x-y}) \cdots \qquad (1)$$

In the formula (1), a, x and y are atomic ratios of Mg, B and C, respectively, and satisfy

$$0.05 \leq a \leq 0.30,$$

$$0 \leq x \leq 0.20$$

and

$$0 \leq y \leq 0.30.$$

Another hard film which could solve the problem(s) is a hard film including Cr and Mg of the (Cr,Mg)(B,C,N) film and M described below. The hard film is a hard film to be formed on/above a substrate, which satisfies a composition represented by the following formula (2).

$$Cr_{1-a-b}Mg_aM_b(B_xC_yN_{1-x-y}) \cdots \qquad (2)$$

In the formula (2), M is one or more elements selected from the group consisting of W, Mo, V, Zr, Hf and Nb, and a, b, x and y are atomic ratios of Mg, M, B and C, respectively, and satisfy

$$0.05 \leq a \leq 0.30,$$

$$0 < b \leq 0.50,$$

$$0 \leq x \leq 0.20$$

and

$$0 \leq y \leq 0.30.$$

In the other hard film which could solve the problem(s), a layer a which is the (Cr,Mg)(B,C,N) film and has a thickness of 2 to 50 nm and a layer b which satisfies a composition represented by the following formula (3) and has a thickness of 2 to 50 nm are alternately laminated.

$$M(B_xC_yN_{1-x-y}) \cdots \qquad (3)$$

In the formula (3), M is one or more elements selected from the group consisting of W, Mo, V, Zr, Hf and Nb, and x and y are atomic ratios of B and C, respectively, and satisfy

$$0 \leq x \leq 0.20$$

and

$$0 \leq y \leq 0.30.$$

In the present invention, a hard film covering member in which any one of the above hard films is formed on/above the substrate, and a cutting tool for cutting pure titanium or a titanium alloy in which any one of the above hard films is formed on/above the substrate are included.

ADVANTAGEOUS EFFECTS OF THE INVENTION

According to the present invention, there can be provided a hard film which can achieve satisfactory cutting, in the case where it is formed as a hard film of a cutting tool, even when a material to be cut is a titanium-based metal, and a hard film covering member such as a cutting tool in which the hard film is formed on/above a substrate.

MODE FOR CARRYING OUT THE INVENTION

In order to obtain a hard film and a hard film covering member in which the hard film is formed on/above the substrate, the hard film being able to suppress adhesion of a component of a material to be cut during cutting to achieve satisfactory cutting, in the case where it is formed as a hard film of a cutting tool, even when the material to be cut is a titanium-based metal, the present inventors have made intensive studies particularly on the composition of the hard film. First, attention has been focused on a Cr-containing film such as CrN. When the Cr-containing film is used in the cutting tool, Cr oxide is formed on a wear surface by an increase in temperature due to frictional heat generation with the material to be cut, and contributes to improvement of adhesion resistance. The present inventors have found that in the case where the film contains Cr described above and Mg as described below in detail and satisfies a composition represented by the following formula (1), even when applied to a tool for cutting a titanium-based metal, adhesion of the titanium-based metal can be sufficiently suppressed. Respective elements will be described below.

$$Cr_{1-a}Mg_a(B_xC_yN_{1-x-y}) \cdots \qquad (1)$$

In the above formula (1),
a, x and y are the atomic ratios of Mg, B and C, respectively, and satisfy

$$0.05 \leq a \leq 0.30,$$

$$0 \leq x \leq 0.20$$

and

$$0 \leq y \leq 0.30.$$

Mg described above is an element contributing to adhesion suppression of the Ti-based metal as the material to be cut, because of its narrow solid solution region with Ti. In order to exhibit the effect, the atomic ratio a of Mg is adjusted to 0.05 or more. The atomic ratio a of Mg is hereinafter sometimes referred to as "the Mg amount a". The Mg amount a is preferably 0.10 or more, more preferably 0.12 or more, and still more preferably 0.15 or more. On the other hand, when Mg is excessively contained, the film is softened to cause deterioration of wear resistance. Therefore, the Mg amount a is adjusted to 0.30 or less. The Mg amount a is preferably 0.25 or less, and more preferably 0.20 or less.
The atomic ratio 1-a of Cr in formula (1) is a value obtained by subtracting the atomic ratio a of Mg from 1, and numerically 0.70 or more and 0.95 or less. The atomic ratio 1-a of Cr can be adjusted preferably to 0.75 or more, and more preferably to 0.90 or less, still more preferably to 0.88 or less, and particularly preferably to 0.85 or less. The atomic ratio 1-a of Cr in formula (1) is hereinafter sometimes referred to as "the Cr amount 1-a".
The film represented by $Cr_{1-a}Mg_a(B_xC_yN_{1-x-y})$ in the present invention is a nitride, when B and C are zero. Like this, the film of the present invention is basically based on the nitride. However, properties may be changed by adding B or C. By adding B described above, B in the film binds to N to produce a lubricating component, thereby suppressing the adhesion. In order to obtain this adhesion suppressing effect, the atomic ratio x of B can be adjusted, for example, to 0.01 or more, and further to 0.02 or more. The atomic ratio x of B is hereinafter sometimes referred to as "the B amount x". However, when B is excessively contained, the film is made amorphous to cause deterioration of the wear resistance. Therefore, the B amount x is adjusted to 0.20 or less. The B amount x is preferably 0.10 or less.
Further, by adding C described above, the friction coefficient becomes smaller than the case of the nitride, thereby suppressing the adhesion. In order to obtain this adhesion suppressing effect, the atomic ratio y of C can be adjusted, for example, to 0.05 or more, and further to 0.10 or more. The atomic ratio y of C is hereinafter sometimes referred to as "the C amount y". However, when C is excessively contained, free carbon not bonded to a metal is formed in the film to cause deterioration of the wear resistance. Therefore, the C amount y is adjusted to 0.30 or less. The C amount y is preferably 0.20 or less, and more preferably less than 0.15.

The present inventors have further found that when the hard film satisfies a composition represented by the following formula (2) in which M described below is added to Cr and Mg of the above formula (1), the adhesion of the titanium-based metal can be sufficiently suppressed.

$$Cr_{1-a-b}Mg_aM_b(B_xC_yN_{1-x-y}) \cdots \qquad (2)$$

In the above formula (2),
M is one or more elements selected from the group consisting of W, Mo, V, Zr, Hf and Nb, and
a, b, x and y are the atomic ratios of Mg, M, B and C, respectively, and satisfy

$$0.05 \leq a \leq 0.30,$$

$$0 < b \leq 0.50,$$

$$0 \leq x \leq 0.20$$

and

$$0 \leq y \leq 0.30.$$

M will be described below. The ranges and preferred upper and lower limit values of the Mg amount a, the B amount x and the C amount y in the above formula (2) are the same as in the case of the hard film represented by the above formula (1).

In the present invention, M is one or more elements selected from the group consisting of W, Mo, V, Zr, Hf and Nb. These elements are elements which produce oxides having lubricity on the wear surface during the cutting to contribute to improvement of the adhesion resistance. These elements may be used either alone or as a combination of two or more thereof. In order to sufficiently exhibit the above-mentioned effect, the atomic ratio b of M is adjusted to preferably 0.05 or more, and more preferably to 0.10 or more. The atomic ratio b of M is hereinafter sometimes referred to as "the M amount b". However, when M is excessively contained, the wearing rate is increased. Therefore, the M amount b is adjusted to 0.50 or less. The M amount b is preferably 0.40 or less, and more preferably 0.30 or less. In the case where M is one kind of the elements, the above-mentioned M amount b indicates the amount of the one kind of the elements, and in the case where M is a plurality of elements, it indicates the total amount thereof. The same applies hereinafter. When M described above includes at least one of Zr, Hf and Nb, the above-mentioned M amount b is still more preferably 0.20 or less, and yet still more preferably 0.15 or less. On the other hand, when M described above is one or more elements selected from the group consisting of W, Mo and V, that is, when M described above does not include any of Zr, Hf and Nb, the M amount b is still more preferably 0.15 or more, and yet still more preferably 0.20 or more.

Respective oxides of W, Mo and V described above are different in the melting point, and the kind of M recommended is different depending on the degree of a load on the cutting tool during the cutting. The V-containing hard film is suitable for a tool used in cutting with a small load and no increase in the cutting edge temperature, because V oxide has a low melting point. Mo-containing hard film or W-containing hard film is suitable for a tool used in cutting with a higher load and an easy increase in the cutting edge temperature, because Mo oxide and W oxide are higher in the melting point than V oxide. For example, when the material to be cut is the titanium-based metal, the cutting edge temperature is easily increased as described above. It is therefore more preferred to use the hard film containing Mo or W described above as M.

In addition, oxides of Zr, Hf and Nb have extremely high chemical stability, so that when these elements are added, the chemical stability of an oxide film formed becomes extremely high. Therefore, the hard film containing these elements can suppress the adhesion of the material to be cut even in the case of cutting the material to be cut having high reactivity. When these elements are added to obtain stable oxides during the cutting, the effect thereof is exhibited even when these are not added in large amounts. When the addition amount is too large, the hard film is decreased in hardness to cause deterioration of the wear resistance.

The atomic ratio 1-a-b of Cr in the formula (2) is a value obtained by subtracting the atomic ratio a of Mg and the atomic ratio b of M from 1, and numerically 0.20 or more and less than 0.95. The atomic ratio 1-a-b of Cr can be adjusted, for example, to 0.35 or more, and further to 0.55 or more, and can be adjusted, for example, to 0.90 or less, further to 0.85 or less, and still further to 0.80 or less.

Further, the present inventors have found that, in addition to allowing M to be evenly dissolved in solid in the film as represented by the above formula (2), when a compound of M and one or more elements of B, C and N as represented by the following formula (3) is alternately laminated on films having the composition represented by the above formula (1), the same effect as the film having the composition of the above formula (2) is obtained, and furthermore, that an increase in hardness due to multi-layering can also be expected. The ranges and preferred upper and lower limit values of M, the B amount x and the C amount y in the above formula (3) are the same as in the case of the hard film represented by the above formula (1) or formula (2).

$$M(B_xC_yN_{1-x-y}) \cdots \qquad (3)$$

In the above formula (3),
M is one or more elements selected from the group consisting of W, Mo, V, Zr, Hf and Nb, and x and y are the atomic ratios of B and C, respectively, and satisfy

$$0 \leq x \leq 0.20$$

and

$$0 \leq y \leq 0.30.$$

When the film having the composition represented by the above formula (1) is defined as a layer a and the film having the composition represented by the above formula (3) is defined as a layer b, in order to obtain the effect of increasing the hardness by the above-mentioned multi-layering, the thickness of each of the layer a and the layer b is required to be 2 nm or more, and it is preferably 5 nm or more. In addition, the thickness of each of the layer a and the layer b is required to be 50 nm or less, and it is preferably 30 nm or less. The hard film in which the layer a and the layer b are laminated as described above is hereinafter sometimes referred to as the "lamination type hard film".

The thicknesses of the layer a and the layer b are not necessarily required to be the same as each other, and may take any value as long as each of them falls within the above-mentioned range. Preferably, in the case of "the thickness of the layer a > the thickness of the layer b", more excellent adhesion resistance can be obtained. In the lamination type hard film of the present invention, either of the layer a and the layer b may be arranged on a substrate side. Further, it may have such a film structure that the layer a or the layer b present on the substrate side is also present on an outermost surface side, and may have various lamination structures depending on the purpose.

The total thickness of the hard film in which the above-mentioned layers a and layers b are laminated is not limited in any way. However, in order to effectively exhibit the properties of the present invention, the total thickness of the hard film is preferably 0.5 μm or more. However, the total thickness of the film is excessively increased, damage or separation of the film becomes liable to occur during the cutting. Therefore, the total thickness is preferably 10 μm or less, more preferably 5 μm or less, and still more preferably 3 μm or less. It is recommended that the number of lamination of the layers a and the layers b is appropriately controlled so as to satisfy the preferred total thickness described above.

Further, in order to exhibit a function due to the layers a and the layers b in a laminated state to the maximum extent, the number of lamination is preferably 2 or more. From such a viewpoint, it is preferred to decrease the thickness of each of the layers a and the layers b and to increase the number of lamination. The number of lamination used herein is a value when lamination of the single layer a and the single layer b is defined as 1 for the number of lamination.

The thickness of the one layer type hard film having the composition represented by the above formula (1) or formula (2) is also the same as the total thickness of the lamination type hard film.

By providing the hard film described above on the substrate, the hard film covering member having excellent adhesion resistance and wear resistance, such as a tool such as a cutting tool, particularly a cutting tool for cutting pure titanium or a titanium alloy or a die can be realized.

When the hard film of the present invention is formed on/above the substrate, an intermediate layer such as another metal, nitride, carbonitride or carbide may be formed between the substrate and the hard film for the purpose of improving adhesiveness.

The kind of substrate used in the above-mentioned formed body is not particularly limited, and substrates described below are used. That is, examples thereof include WC-based cemented carbides such as WC-Co-based alloys, WC-TiC-Co-based alloys, WC-TiC-(TaC or NbC)-Co-based alloys and WC-(TaC or NbC)-Co-based alloys; cermets such as TiC-Ni-Mo-based alloys and TiC-TiN-Ni-Mo-based alloys; high-speed steels such as SKH51 or SKD61 specified in JIS G 4403 (2006); ceramics; cubic boron nitride sintered bodies; diamond sintered bodies; silicon nitride sintered bodies; mixtures composed of aluminum oxide and titanium carbide; and the like.

The hard film of the present invention can be formed on/above a surface of the substrate using a known method such as a PVD process (physical vapor deposition process) or a CVD process (chemical vapor deposition process). As such a process, for example, an ion plating process such as an AIP (arc ion plating) process or a reactive PVD process such as a sputtering process is effective.

Examples of methods for forming the hard film having the composition of the above formula (1), that is, which is also the layer a of the lamination type hard film, include the following method(s). For example, the film is formed using a target containing Cr and Mg as components other than C and N constituting the layer a and further containing B as needed, as a target which is an evaporation source, and using a nitrogen gas or a hydrocarbon gas such as methane or acetylene, as an atmosphere gas. The above-mentioned atmosphere gas may contain an Ar gas. Alternatively, the film may be formed using a target composed of a compound having a component composition constituting the layer a, that is, a target composed of a nitride, a carbonitride, a boronitride or a carboboronitride.

Methods for forming the hard film having the composition of the above formula (2) include the following method. For example, the film is formed using a target containing Cr, Mg and M as components other than C and N constituting the above-mentioned layer and further containing B as needed, as a target which is an evaporation source, and using a nitrogen gas or a hydrocarbon gas such as methane or acetylene, as an atmosphere gas. The above-mentioned atmosphere gas may contain an Ar gas. Alternatively, the film may be formed using a target composed of a compound satisfying the composition of the above formula (2), that is, a target composed of a nitride, a carbonitride, a boronitride or a carboboronitride.

Methods for forming the layer b having the composition of the above formula (3) include the following method. For example, the film is formed using a target containing M as a component other than C and N constituting the layer b and further containing B as needed, as a target which is an evaporation source, and using a nitrogen gas or a hydrocarbon gas such as methane or acetylene, as an atmosphere gas. The above-mentioned atmosphere gas may contain an Ar gas. Alternatively, the film may be formed using a target composed of a compound satisfying the composition of the above formula (3), that is, a target composed of a nitride, a carbonitride, a boronitride or a carboboronitride.

As an apparatus for forming the above-mentioned hard film, it is possible to use, for example, a PVD composite device including both of an arc evaporation source and a sputtering evaporation source, which is shown in FIG. 1 of JP-A-2008-024976. By discharging these evaporation sources at the same time, deposition of elements difficult to be evaporated, such as W, can be performed by the sputtering process, while securing deposition at high speed by the AIP process. In addition, when the lamination type hard film is formed, for example, of four positions of the evaporation sources, layer a forming targets are attached to two positions, and layer b forming targets are attached to the other two positions. Then, they are alternately discharged, thereby alternately laminating the layers a and the layers b. Of the layer a and the layer b, it is also possible to form one by the ion plating process and the other by the sputtering process.

When the above-mentioned PVD composite device is used, for example, the following deposition conditions can be adopted. That is, the temperature of the substrate during the deposition may be appropriately selected depending on the kind of the substrate. From the viewpoint of securing adhesiveness between the substrate and the hard film, it can be adjusted to 300°C or higher, and further to 400°C or higher. In addition, from the viewpoint of deformation prevention and the like of the substrate, the temperature of the substrate can be adjusted to 700°C or lower, and further to 600°C or lower.

Further, as other deposition conditions, the total pressure of the atmosphere gas: 0.5 Pa or more and 4 Pa or less, the arc current: 100 A to 200 A, the bias voltage applied to the substrate: -30 V to -200 V, the electric power inputted into the sputtering evaporation source: 0.1 kW to 3 kW, and the like can be adopted.

EXAMPLES

The present invention will be more specifically described below with reference to Examples. However, the present invention should not be construed as being limited by the following Examples, and can, of course, be carried out with appropriate changes within the scope adaptable to the gist described above and below. All of these are included in the technical scope of the present invention.

Example 1

Films having the compositions shown in Table 1 were formed using a PVD deposition apparatus having a plurality of arc evaporation sources or sputtering evaporation sources. As substrates, a mirrored cemented carbide test piece of 13 mm square × 4 mm thick was prepared for hardness investigation, and an insert (CNMG432, cemented carbide) was prepared for a cutting test. Deposition was performed on these substrates at the same time. In detail, these substrates were introduced into the deposition apparatus, and then, after exhaustion to $5×10^{-3}$ Pa, the substrates were heated to 500°C and subjected to etching with Ar ions for 5 minutes. Thereafter, only nitrogen or a mixed gas of nitrogen and a methane gas was introduced up to 4 Pa, and films of about 3 μm were formed at an arc current of 150 A and a bias voltage applied to the substrates of -50 V to obtain a sample for the hardness investigation and a sample for the cutting test. In the above-mentioned deposition, there were used targets containing Cr and Mg, which were components other than C and N constituting each film, and further containing M or B in some examples. In Table 1, when the kind of M is plural, the M amount in Table 1 is the total of the atomic ratios of respective elements, and the atomic ratio of each element is obtained by equally dividing the M amount in Table 1. The same applies to Table 2. Further, as comparative examples, samples in which a TiN film and a TiAlN film were each formed were prepared.

Using the sample for the hardness investigation and the sample for the cutting test thus obtained, the hardness investigation and the cutting test were performed as follows.

Hardness investigation

Using the above-mentioned sample for the hardness investigation, the Vickers hardness was measured under conditions of a load of 1 N.

Cutting test

It is said that the progress of wear in the case of cutting the Ti-based metal is mainly due to adhesion wear. In this example, therefore, the adhesion resistance was evaluated by the following flank wear amount. That is, using the above-mentioned sample for the cutting test, the cutting test was performed under the following conditions, and the adhesion resistance was evaluated by the flank wear amount at the time of 1000 m cutting, as shown below. The flank wear amount at the time of 1000 m cutting is hereinafter simply referred to as the "wear amount".

Cutting test conditions

Tool: CNMG432, material; K313
Material to be cut: Ti-6Al-4V
Speed: 45 m/min
Feed: 0.15 mm/min
DOC (Depth Of Cut): 2 mm
Lubrication: Wet
Evaluation: Flank wear amount at the time of 1000 m cutting

When the wear amount is smaller and the above-mentioned Vickers hardness is higher, the adhesion resistance and the wear resistance are evaluated to be more excellent, and the tool life is evaluated to be longer. The results thereof are shown in Table 1.

[Table 1]

| No. | Composition of Film (Atomic Ratio) | | | | | | | Vickers Hardness HV | Flank Wear Amount (μm) |
|---|---|---|---|---|---|---|---|---|---|
| | Cr | Mg | Kind of M | M Amount | B | C | N | | |
| 1 | TiN | | | | | | | 2100 | 300 |
| 2 | TiAlN | | | | | | | 2500 | 200 |
| 3 | 1.00 | 0 | - | 0 | 0 | 0 | 1 | 1500 | 180 |
| 4 | 0.97 | 0.03 | - | 0 | 0 | 0 | 1 | 1600 | 170 |

(continued)

| No. | Composition of Film (Atomic Ratio) | | | | | | | Vickers Hardness HV | Flank Wear Amount (μm) |
|---|---|---|---|---|---|---|---|---|---|
| | Cr | Mg | Kind of M | M Amount | B | C | N | | |
| 5 | 0.94 | 0.06 | - | 0 | 0 | 0 | 1 | 2100 | 85 |
| 6 | 0.90 | 0.10 | - | 0 | 0 | 0 | 1 | 2400 | 70 |
| 7 | 0.85 | 0.15 | - | 0 | 0 | 0 | 1 | 2700 | 65 |
| 8 | 0.80 | 0.20 | - | 0 | 0 | 0 | 1 | 2800 | 70 |
| 9 | 0.70 | 0.30 | - | 0 | 0 | 0 | 1 | 2700 | 80 |
| 10 | 0.60 | 0.40 | - | 0 | 0 | 0 | 1 | 1500 | 150 |
| 11 | 0.85 | 0.15 | - | 0 | 0.05 | 0 | 0.95 | 2800 | 65 |
| 12 | 0.85 | 0.15 | - | 0 | 0.10 | 0 | 0.90 | 2900 | 60 |
| 13 | 0.85 | 0.15 | - | 0 | 0.20 | 0 | 0.80 | 2800 | 80 |
| 14 | 0.85 | 0.15 | - | 0 | 0.30 | 0 | 0.70 | 1900 | 140 |
| 15 | 0.85 | 0.15 | - | 0 | 0 | 0.10 | 0.90 | 2700 | 65 |
| 16 | 0.85 | 0.15 | - | 0 | 0 | 0.30 | 0.70 | 2900 | 60 |
| 17 | 0.85 | 0.15 | - | 0 | 0 | 0.40 | 0.60 | 1800 | 140 |
| 18 | 0.85 | 0.15 | - | 0 | 0.03 | 0.12 | 0.85 | 3000 | 55 |
| 19 | 0.80 | 0.15 | W | 0.05 | 0 | 0 | 1 | 2700 | 65 |
| 20 | 0.75 | 0.15 | W | 0.10 | 0 | 0 | 1 | 2800 | 60 |
| 21 | 0.70 | 0.15 | W | 0.15 | 0 | 0 | 1 | 3100 | 50 |
| 22 | 0.60 | 0.15 | W | 0.25 | 0 | 0 | 1 | 3100 | 45 |
| 23 | 0.55 | 0.15 | W | 0.30 | 0 | 0 | 1 | 2800 | 60 |
| 24 | 0.35 | 0.15 | W | 0.50 | 0 | 0 | 1 | 2700 | 65 |
| 25 | 0.15 | 0.15 | W | 0.70 | 0 | 0 | 1 | 1800 | 130 |
| 26 | 0.75 | 0.10 | V | 0.15 | 0 | 0 | 1 | 3000 | 55 |
| 27 | 0.75 | 0.10 | Mo | 0.15 | 0 | 0 | 1 | 3100 | 50 |
| 28 | 0.70 | 0.10 | Mo, W | 0.20 | 0 | 0 | 1 | 3100 | 45 |
| 29 | 0.75 | 0.10 | Mo, W, V | 0.15 | 0 | 0 | 1 | 3000 | 50 |
| 30 | 0.70 | 0.10 | W | 0.20 | 0.10 | 0 | 0.90 | 3000 | 50 |
| 31 | 0.70 | 0.10 | W | 0.20 | 0.10 | 0.20 | 0.70 | 2900 | 60 |
| 32 | 0.40 | 0.10 | Zr | 0.50 | 0 | 0 | 1 | 2700 | 55 |
| 33 | 0.70 | 0.10 | Zr | 0.20 | 0 | 0 | 1 | 2900 | 50 |
| 34 | 0.80 | 0.10 | Zr | 0.10 | 0 | 0 | 1 | 3200 | 40 |
| 35 | 0.80 | 0.10 | Hf | 0.10 | 0 | 0 | 1 | 3100 | 50 |
| 36 | 0.80 | 0.10 | Nb | 0.10 | 0 | 0 | 1 | 3000 | 55 |
| 37 | 0.80 | 0.10 | Zr, Hf | 0.10 | 0 | 0 | 1 | 3200 | 45 |
| 38 | 0.80 | 0.10 | Zr, Hf | 0.10 | 0 | 0 | 1 | 3100 | 35 |

The following is found from Table 1. The cases of Nos. 1 and 2 of Table 1 are examples in which the conventionally used TiN film and TiAlN film were each formed. In these films, the wear amount was extremely large, resulting in poor adhesion resistance and wear resistance.

The cases of Nos. 3 to 18 are examples corresponding to the composition of the specified formula (1).

Of these, the cases of Nos. 3 to 10 are examples in which the composition of Cr and Mg in CrMgN was changed. In the case where Mg was not contained or insufficient even when Mg was contained, as in the cases of Nos. 3 and 4, the hardness was low, and the wear amount was also large, although not so large as in the cases of Nos. 1 and 2, resulting in poor adhesion resistance and wear resistance. In the case of No. 10, the Mg amount a was excessive, so that the hardness was low, and the wear amount was also large, although not so large as in the cases of Nos. 1 and 2, resulting in poor adhesion resistance and wear resistance. In contrast, in the cases of Nos. 5 to 9, the composition specified in the present invention was satisfied, the Vickers hardness was 2100 Hv or more, and the wear amount was suppressed to 85 μm or less. Preferably, when the Mg amount a was 0.10 or more and 0.30 or less, a Vickers hardness of 2400 Hv or more and a wear amount of 80 μm or less were achieved, as in the cases of Nos. 6 to 9, and particularly, when the Mg amount a was 0.15 or more and 0.30 or less, a Vickers hardness of 2700 Hv or more and a wear amount of 80 μm or less were achieved, as in the cases of Nos. 7 to 9.

The cases of Nos. 11 to 18 are examples in which the composition of B, C and N of the film having a Cr amount 1-a of 0.85 and a Mg amount a of 0.15 in the case of No. 7 described above was changed. The cases of Nos. 11 to 14 are examples in which the composition of B and N of the boronitride was changed. Of these, in the case of No. 14, the B amount x was excessive, so that the hardness was low and the wear amount was also large, resulting in poor adhesion resistance and wear resistance. On the other hand, in the cases of Nos. 11 to 13, the composition specified in the present invention was satisfied, and the hardness higher than that in the case of No. 7 described above was obtained. In addition, as shown in the cases of Nos. 11 and 12, when the B amount x was particularly 0.10 or less, the wear amount was decreased, and more excellent adhesion resistance and wear resistance were obtained.

Further, the cases of Nos. 15 to 17 are examples in which the composition of C and N of the carbonitride was changed. Of these, in the case of No. 17, the C amount y was excessive, so that the hardness was low and the wear amount was large, resulting in poor adhesion resistance and wear resistance. On the other hand, in the cases of Nos. 15 and 16, the composition specified in the present invention was satisfied, so that the adhesion resistance and wear resistance equivalent to or more excellent than those in the case of No. 7 were obtained.

The case of No. 18 is a film in which all of B, C and N are contained within a range satisfying the composition specified in the present invention. This film could achieve the hardness higher and the wear amount smaller than those in the case of No. 7 described above, and excellent adhesion resistance and wear resistance were obtained.

The cases of Nos. 19 to 38 are examples corresponding to the composition of the specified formula (2).

Of these, the cases of Nos. 19 to 25 are examples in which W was added as M by changing the M amount b to the film having a Mg amount a of 0.15 in the case of No. 7 described above. In the case of No. 25, the M amount b was excessive, so that the hardness was low and the wear amount was also large, resulting in poor adhesion resistance and wear resistance. On the other hand, in the cases of Nos. 19 to 24, the composition specified in the present invention was satisfied, and excellent adhesion resistance and wear resistance of a hardness of 2700 Hv or more and a wear amount of 65 μm or less were obtained. As shown in the case of No. 20, it is found that the adhesion resistance and the wear resistance more excellent than those in the case of No. 7 described above can be secured by adjusting the lower limit of the M amount b to preferably 0.10 or more. In addition, it is found that the adhesion resistance and the wear resistance more excellent than those in the case of No. 7 described above can be secured by adjusting the upper limit of the M amount b to preferably 0.30 or less.

The cases of Nos. 26 to 29 are examples in which V and/or Mo were used as M in place of or in addition to W described above. In all of the examples, the composition specified in the present invention was satisfied, and sufficiently excellent adhesion resistance and wear resistance of a Vickers hardness of 3000 Hv or more and a wear amount of 55 μm or less were obtained.

The cases of Nos. 30 and 31 are examples in which M was W and the composition of B, C and N was changed. In these examples, the composition specified in the present invention was satisfied, and sufficiently excellent adhesion resistance and wear resistance of a Vickers hardness of 2900 Hv or more and a wear amount of 60 μm or less were obtained.

The cases of Nos. 32 to 38 are examples in which Zr, Hf or Nb was used as M in place of W described above. In all of the examples, the composition specified in the present invention was satisfied, and sufficiently excellent adhesion resistance and wear resistance of a Vickers hardness of 2700 Hv or more and a wear amount of 55 μm or less were obtained.

Example 2

Films in which the layers a and layers b shown in Table 2 were alternately laminated were formed using a PVD deposition apparatus having a plurality of arc evaporation sources or sputtering evaporation sources. As substrates, a mirrored cemented carbide test piece of 13 mm square × 4 mm thick was prepared for hardness investigation, and an insert (CNMG432, cemented carbide) was prepared for a cutting test. Deposition was performed on these substrates at the same time. In detail, these substrates were introduced into the deposition apparatus, and then, after exhaustion to $5 \times 10^{-3}$ Pa, the substrates were heated to 500°C and subjected to etching with Ar ions for 5 minutes. Thereafter, a mixed gas of nitrogen and an Ar gas was introduced up to 2.7 Pa, and a CrN film of about 100 nm was formed by an AIP process as an intermediate layer for enhancing adhesiveness between the substrate and the laminated film. Subsequently, the AIP evaporation source and the sputtering evaporation source were discharged at the same time under the conditions of the above-mentioned substrate temperature and the above-mentioned total gas pressure, and layers a having the composition and thickness shown in Table 2 and layers b having the composition and thickness shown in Table 2 were alternately laminated to form multilayer films having a total thickness of about 3 $\mu$m, thus obtaining a sample for the hardness investigation and a sample for the cutting test. In the deposition of the above-mentioned layers a, there was used a target containing Cr and Mg, which were components other than C and N constituting each film, and further B in some examples, and in the deposition of the above-mentioned layers b, there was used a target containing M constituting each film, and further B in some examples. In the formation of a carbon-containing layer, a methane gas was used together as an atmosphere gas. Using these samples, the Vickers hardness was measured, and the cutting test was performed to measure the flank wear amount at the time of 1000 m cutting. The results thereof are shown in Table 2.

[Table 2]

| No. | Layer a | | Layer b | | Vickers Hardness Hv | Flank Wear Amount ($\mu$m) |
|---|---|---|---|---|---|---|
| | Composition (Atomic Ratio) | Thickness (nm) | Composition (Atomic Ratio) | Thickness (nm) | | |
| 1 | Cr0.90Mg0.10N | 2 | WN | 2 | 2700 | 90 |
| 2 | Cr0.90Mg0.10N | 5 | WN | 5 | 2900 | 75 |
| 3 | Cr0.90Mg0.10N | 10 | WN | 10 | 3000 | 50 |
| 4 | Cr0.90Mg0.10N | 20 | WN | 20 | 2800 | 80 |
| 5 | Cr0.90Mg0.10N | 50 | WN | 50 | 2700 | 80 |
| 6 | Cr0.90Mg0.10N | 75 | WN | 75 | 1800 | 90 |
| 7 | Cr0.90Mg0.10N | 100 | WN | 100 | 1800 | 90 |
| 8 | Cr0.90Mg0.10N | 1500 | WN | 1500 | 1600 | 120 |
| 9 | Cr0.90Mg0.10N | 10 | W(C0.10N0.9) | 10 | 3000 | 55 |
| 10 | Cr0.90Mg0.10N | 10 | W(B0.10N0.9) | 10 | 3000 | 50 |
| 11 | Cr0.90Mg0.10N | 20 | WN | 2 | 3100 | 50 |
| 12 | Cr0.90Mg0.10N | 20 | WN | 5 | 3200 | 45 |
| 13 | Cr0.90Mg0.10N | 20 | WN | 10 | 2800 | 70 |
| 14 | Cr0.90Mg0.10N | 20 | WN | 15 | 2800 | 80 |
| 15 | Cr0.90Mg0.10N | 20 | VN | 5 | 2900 | 60 |
| 16 | Cr0.90Mg0.10N | 20 | MoN | 5 | 3000 | 50 |
| 17 | Cr0.90Mg0.10N | 20 | (V,Mo)N | 5 | 2900 | 55 |
| 18 | Cr0.90Mg0.10N | 20 | (V,Mo,W)N | 5 | 3100 | 50 |
| 19 | Cr0.90Mg0.10 (B0.10N0.90) | 20 | WN | 10 | 2800 | 65 |
| 20 | Cr0.90Mg0.10 (C0.20N0.80) | 20 | WN | 10 | 2800 | 70 |
| 21 | Cr0.90Mg0.10N | 20 | ZrN | 5 | 3200 | 40 |
| 22 | Cr0.90Mg0.10N | 20 | ZrN | 5 | 3200 | 40 |
| 23 | Cr0.90Mg0.10N | 20 | (Zr0.50Hf0.50)N | 5 | 3100 | 45 |
| 24 | Cr0.90Mg0.10N | 20 | (Zr0.50Nb0.50)N | 5 | 3000 | 50 |

The following is found from Table 2. The cases of Nos. 1 to 8 are examples in which the layers a were same as those in CrMgN shown in Table 2, the layers b were WN, the thickness of the layers a was the same as the thickness of the layers b, and the thicknesses thereof were changed. Of these examples, in the cases of Nos. 1 to 5, the compositions and the thicknesses of the layers a and the layers b satisfied the ranges specified in the present invention, so that the hardness was high and the wear amount was also suppressed, resulting in excellent adhesion resistance and wear resistance. In contrast, in the cases of Nos. 6 to 8, the thicknesses of both of the layers a and the layers b exceeded the specified range, so that the hardness was decreased. In particular, in the case of No. 8, the wear amount was also increased, resulting in poor adhesion resistance and wear resistance.

All of the cases of Nos. 9 to 24 are lamination type hard films satisfying the compositions and the thicknesses specified in the present invention. In these examples, excellent adhesion resistance and wear resistance of a Vickers hardness of 2800 Hv or more and a wear amount of 80 $\mu$m or less were obtained.

Of these, the cases of Nos. 9 and 10 are examples in which the composition of the layers b in the case of No. 3 described above was changed to a carbonitride and a boronitride, respectively. When the case of No. 3 described above was compared with the cases of Nos. 9 and 10, even in the case where the layers b were composed of the carbonitride or the boronitride, the hardness was high, and the wear amount was suppressed.

The cases of Nos. 11 to 14 are examples in which the thickness of the layers b in the case of No. 4 described above was changed. When the case of No. 4 was compared with the cases of Nos. 11 to 14, even in the case where the thickness of the layers b was different, the hardness was high and the above-mentioned flank wear amount was small, resulting in obtaining excellent adhesion resistance and wear resistance. From these results, it was found that in the case of "the thickness of the layers a > the thickness of the layers b", the larger the thickness of the layers a was increased than the thickness of the layers b, the more excellent adhesion resistance and wear resistance tended to be obtained.

The cases of Nos. 15 to 18 are examples in which the composition of layers b in the case of No. 12 described above was changed. From these results, it was found that even when M was a metal other than W and even when a plurality of thereof were used, the hardness was high and the wear amount was suppressed, resulting in obtaining excellent adhesion resistance and wear resistance.

The cases of Nos. 19 and 20 are examples in which the composition of the layers a in the case of No. 13 was changed to use a boronitride and a carbonitride, respectively. From these results, it was found that even when the compound containing B or C was used as the layers a in place of the nitride, the hardness was high and the wear amount was suppressed, resulting in obtaining excellent adhesion resistance and wear resistance.

The cases of Nos. 21 to 24 are examples in which the composition of the layers b in the case No. 12 was changed. From these results, it was found that even when M contained at least any one of Zr, Hf and Nb, the hardness was high and the wear amount was suppressed, resulting in obtaining excellent adhesion resistance and wear resistance.

While the present invention has been described in detail with reference to specific embodiments, it will be apparent to those skilled in the art that various changes and modifications can be made without departing from the spirit and scope of the present invention.

The present invention is based on Japanese Patent Application No. 2015-021432 filed on February 5, 2015 and Japanese Patent Application No. 2015-094995 filed on May 7, 2015, the contents of which are incorporated herein by reference.

INDUSTRIAL APPLICABILITY

The hard film of the present invention can be applied as a coating for improving wear resistance to a tool such as a cutting tool or a die. In particular, it is suitable for a cutting tool to be used for cutting a titanium-based metal such as pure titanium or a titanium alloy as a material to be cut.

**Claims**

1. A hard film to be formed on/above a substrate, which satisfies a composition represented by the following formula (1):

$$Cr_{1-a}Mg_a(B_xC_yN_{1-x-y}) \cdots \qquad (1)$$

wherein a, x and y are atomic ratios of Mg, B and C, respectively, and satisfy

$$0.05 \leq a \leq 0.30,$$

$$0 \leq x \leq 0.20$$

and

$$0 \leq y \leq 0.30.$$

2. A hard film to be formed on/above a substrate, which satisfies a composition represented by the following formula (2):

$$Cr_{1-a-b}Mg_aM_b(B_xC_yN_{1-x-y}) \cdots \qquad (2)$$

wherein M is one or more elements selected from the group consisting of W, Mo, V, Zr, Hf and Nb, and a, b, x and y are atomic ratios of Mg, M, B and C, respectively, and satisfy

$$0.05 \leq a \leq 0.30,$$

$$0 < b \leq 0.50,$$

$$0 \leq x \leq 0.20$$

and

$$0 \leq y \leq 0.30.$$

3. A hard film, wherein a layer a which is the hard film according to claim 1 and has a thickness of 2 to 50 nm and a layer b which satisfies a composition represented by the following formula (3) and has a thickness of 2 to 50 nm are alternately laminated:

$$M(B_xC_yN_{1-x-y}) \cdots \qquad (3)$$

wherein M is one or more elements selected from the group consisting of W, Mo, V, Zr, Hf and Nb, and x and y are atomic ratios of B and C, respectively, and satisfy

$$0 \leq x \leq 0.20$$

and

$$0 \leq y \leq 0.30.$$

4. A hard film covering member in which the hard film according to any one of claims 1 to 3 is formed on/above the substrate.

5. A cutting tool for cutting pure titanium or a titanium alloy, in which the hard film according to any one of claims 1 to 3 is formed on/above the substrate.

## INTERNATIONAL SEARCH REPORT

| International application No. |
| --- |
| PCT/JP2015/084914 |

**A.  CLASSIFICATION OF SUBJECT MATTER**
*B23B27/14*(2006.01)i, *C23C14/06*(2006.01)n

According to International Patent Classification (IPC) or to both national classification and IPC

**B.  FIELDS SEARCHED**

Minimum documentation searched (classification system followed by classification symbols)
B23B27/14, C23C14/06, B23B51/00, B23C5/20, B23P15/28

Documentation searched other than minimum documentation to the extent that such documents are included in the fields searched
Jitsuyo Shinan Koho          1922–1996   Jitsuyo Shinan Toroku Koho   1996–2016
Kokai Jitsuyo Shinan Koho    1971–2016   Toroku Jitsuyo Shinan Koho   1994–2016

Electronic data base consulted during the international search (name of data base and, where practicable, search terms used)
WPI

**C.  DOCUMENTS CONSIDERED TO BE RELEVANT**

| Category* | Citation of document, with indication, where appropriate, of the relevant passages | Relevant to claim No. |
| --- | --- | --- |
| X<br>A | JP 2006-265679 A  (Nagaoka University of Technology),<br>05 October 2006 (05.10.2006),<br>paragraphs [0007] to [0016]; fig. 1 to 3<br>(Family: none) | 1,4-5<br>2-3 |
| A | JP 2014-77201 A  (Oerlikon Trading AG. Truebbach),<br>01 May 2014 (01.05.2014),<br>entire text; all drawings<br>& WO 2008/043606 A1      & CA 2665044 A<br>& KR 10-2009-0074035 A   & CN 101522950 A | 1-5 |
| A | JP 2012-72500 A  (Kobe Steel, Ltd.),<br>12 April 2012 (12.04.2012),<br>entire text; all drawings<br>(Family: none) | 1-5 |

☒  Further documents are listed in the continuation of Box C.          ☐   See patent family annex.

| | |
| --- | --- |
| *       Special categories of cited documents:<br>"A"   document defining the general state of the art which is not considered    to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
| --- | --- |
| 29 January 2016 (29.01.16) | 09 February 2016 (09.02.16) |

| Name and mailing address of the ISA/ | Authorized officer |
| --- | --- |
| Japan Patent Office<br>3-4-3,Kasumigaseki,Chiyoda-ku,<br>Tokyo 100-8915,Japan | |
| | Telephone No. |

Form PCT/ISA/210 (second sheet) (January 2015)

**INTERNATIONAL SEARCH REPORT**

International application No.

PCT/JP2015/084914

C (Continuation). DOCUMENTS CONSIDERED TO BE RELEVANT

| Category* | Citation of document, with indication, where appropriate, of the relevant passages | Relevant to claim No. |
|---|---|---|
| A | JP 2009-1906 A (Sulzer Metaplas GmbH), 08 January 2009 (08.01.2009), entire text; all drawings & US 2009/0130465 A1 & EP 2022870 A2 | 1-5 |
| A | JP 2008-73800 A (Kobe Steel, Ltd.), 03 April 2008 (03.04.2008), entire text; all drawings & US 2008/0075976 A1 & DE 102007039193 A1 & CN 101148750 A & KR 10-2008-0027156 A | 1-5 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005262389 A
- JP H09216104 A
- JP 2008024976 A
- JP 2015 A
- JP 021432 A
- JP 2015094995 A